(19)

**Europäisches Patentamt**
**European Patent Office**
**Office européen des brevets**

(11) **EP 1 965 282 A2**

(12) **EUROPEAN PATENT APPLICATION**

(43) Date of publication:
**03.09.2008 Bulletin 2008/36**

(51) Int Cl.:
**G05B 19/418** (2006.01)

(21) Application number: **08152072.8**

(22) Date of filing: **28.02.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **02.03.2007 US 681394**

(71) Applicant: **Applied Materials, Inc.**
**Santa Clara, CA 95054 (US)**

(72) Inventors:
• **Emani, Shyam**
**Santa Clara, CA 95051 (US)**

• **Wang, Chongyang**
**San Jose, CA 95148 (US)**
• **Hickerson, Stephen**
**Hollister, CA 95023 (US)**
• **Swenberg, Johanes**
**Los Gatos, CA 95032 (US)**
• **Newman, Jacob**
**Palo Alto, CA 94301 (US)**

(74) Representative: **Zimmermann & Partner**
**Josephspitalstrasse 15**
**80331 München (DE)**

(54) **Software sequencer for integrated substrate processing system**

(57) Embodiments of the invention generally provide apparatus and method for scheduling a process sequence to achieve maximum throughput and process consistency in a cluster tool having a set of constraints. One embodiment of the present invention provides a method for scheduling a process sequence comprising determining (410) an initial individual schedule by assigning resources to perform the process sequence (200), calculating (420) a fundamental period, detecting (440) resource conflicts in a schedule generated from the individual schedule and the fundamental period, and adjusting (450) the individual schedule to remove the resource conflicts.

FIG. 6

EP 1 965 282 A2

**Description**

The present invention generally relates to methods for scheduling a process sequence and a computer readable medium. In particular, it relates to methods for scheduling a process sequence and a computer readable medium containing a computer program for scheduling a process sequence. Embodiments of the present invention generally relate to apparatus and methods for transferring semiconductor substrates in an integrated processing system. More particularly, embodiments of the present invention relate to integrated substrate processing systems having a software sequencer that provides substrate to substrate timing consistency.

In modern semiconductor processing, multilayered features are fabricated on semiconductor substrates using specific processing recipes having many processing steps. A cluster tool, which integrates a number of process chambers to perform a process sequence without removing substrates from a processing environment, usually a controlled environment, is generally used in processing semiconductor substrates. A process sequence is generally defined as the sequence of device fabrication steps, or process recipe steps, completed in one or more processing chambers in a cluster tool. A process sequence may generally contain various substrate (or wafer) electronic device fabrication processing steps.

Over the years, semiconductor device manufactures have been facing a dilemma between system throughput and process consistency to stay competitive.

On one hand, effectiveness of a substrate fabrication process directly affects a device manufacture's competitiveness. On the other hand, reduced feature size of semiconductor devices has resulted in semiconductor manufacturing specifications having more stringent requirements for process consistency and repeatability.

The effectiveness of a substrate fabrication process is often measured by two related and important factors, which are device yield and cost of ownership (CoO). CoO, while affected by a number of factors, is greatly affected by system and chamber throughput, or simply the number of substrates processed per hour using a desired processing sequence.

In an effort to reduce CoO, electronic device manufacturers often spend a large amount of time trying to optimize the process sequence and chamber processing time to achieve the greatest substrate throughput possible given the cluster tool architecture limitations and the chamber processing times. System throughput may be increased by shortening chamber limit and/or robot limit. Chamber limit is decided by time consumed by the longest process recipe step of the processing sequence. Robot limit is decided by time consumed for transferring the substrate by a robot.

For some processing sequences, such as thermal processing and wet processing, process consistency and repeatability closely relates to timing consistency. Time consistency maybe achieved by good control over substrate transfer time between chambers and substrate queue time which is the amount of time a substrate remains in a chamber after a recipe step.

Semiconductor manufactures sometimes need to determine trade offs between throughput and process consistency. For example, on one hand, adding substrate queue time within a queue time sensitivity limit between processing steps is an effective way to achieve process consistency and repeatability. On the other hand, added substrate queue time may increase chamber limit/robot limit resulting in decreased system throughput.

To ensure uniform substrate surface properties, it is desirable that all substrates have consistent timing at each step of a process sequence. In the state of the art system, a limited look-ahead algorithm is used in substrate scheduling to prevent dead locks. The limited look-ahead algorithm can stabilize the system to a maximum throughput value. After the steady state is reached, all the substrates having the same queue time at each step. However, until the steady state is reaches, different substrates will exhibit different behavior based on the state of the system. For example, the first substrate will not have any wait time since all the resources are free at this point. But the subsequent substrate may have to wait in some steps. Additionally, the substrate queue time is decided by the steady state and there is no way to constraint the queue time. Thus, some processing steps with high queue time sensitivity may be compromised at the steady state.

Therefore, there exists a need in a cluster tool for apparatus and method to determine optimal throughput and process consistency.

In light of the above, embodiments of the invention generally provide apparatus and method for scheduling a process sequence to achieve maximum throughput and process consistency in a cluster tool having a set of constraints.

In one aspect, the present invention provides a method for scheduling a process sequence comprising determining an initial individual schedule by assigning resources to perform the process sequence, calculating a fundamental period, detecting resource conflicts in a schedule generated from the individual schedule and the fundamental period, and adjusting the individual schedule to remove the resource conflicts.

One embodiment of the present invention provides a method for scheduling a process sequence comprising determining an individual schedule by assigning resources to perform the process sequence, wherein the individual schedule comprises a start time when an individual substrate starts each of a plurality of process steps in the process sequence, calculating a fundamental period, wherein the fundamental period is defined as time duration between start times of two sequential substrates, detecting resource conflicts in a schedule generated from the individual schedule and the fundamental period, and adjusting the individual schedule to remove a detected resource conflict.

Another embodiment of the present invention provides a computer readable medium containing a computer program for scheduling a process sequence, which, when executed by a process, performs operations comprising determining an individual schedule by assigning resources to perform the process sequence, wherein the individual schedule comprises a start time when an individual substrate starts each of a plurality of process steps in the process sequence, calculating a fundamental period, wherein the fundamental period is defined as time duration between start times of two sequential substrates, detecting resource conflicts in a schedule generated from the individual schedule and the fundamental period, and adjusting the individual schedule to remove a detected resource conflict.

Yet another embodiment of the present invention provides a method for scheduling a processing sequence comprising generating a processing schedule wherein there is no waiting period for each of a plurality of processing steps in the processing sequence, determining a fundamental period according to a busy duration of a bottle neck resource, detecting resource conflicts in the processing schedule based on the fundamental period, and adjusting at least one of the processing schedule and the fundamental period to remove the detected resource conflicts.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

It is contemplated that elements of one embodiment may be advantageously utilized in other embodiments without further recitation.

Further advantages, features, aspects and details are evident from the dependent claims, the description and the drawings.

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments. The accompanying drawings relate to embodiments of the invention and are described in the following:

Figure 1 schematically illustrates a cluster tool for semiconductor processing in accordance with one embodiment of the present invention.

Figure 2 illustrates a flow chart of a process sequence for deposition a gate stack.

Figure 3A schematically illustrates a flow chart of an exemplary process sequence in accordance with one embodiment of the present invention.

Figure 3B schematically illustrates a route of substrates processed in the process sequence of Figure 3A in the cluster tool of Figure 1.

Figure 4 schematically illustrates a recipe diagram for a schedule table for the process sequence of Figure 3A without queue time.

Figure 5 schematically illustrates a recipe diagram for an updated schedule table of Figure 4 in accordance with one embodiment of the present invention.

Figure 6 illustrates a flow chart of a scheduling method in accordance with one embodiment of the present invention.

Figure 7 illustrates a flow chart of a method to remove resource conflicts in accordance with one embodiment of the present invention.

Figure 8 illustrates a flow chart of a method for determining a periodic cleaning schedule in accordance with one embodiment of the present invention.

Embodiments of the invention generally provide an apparatus and method for processing substrates using a multi-chamber processing system. More particularly, embodiments of the present invention provide methods for scheduling a given process sequence. The scheduling method of the present invention allows all the substrates in the system to have consistent queue times at each step of the process sequence to ensure uniform substrate properties. The scheduling method of the present invention comprises determining a schedule by assigning resources in a cluster tool for performing a given process sequence, and determining a fundamental period, time period between sending two sequential substrates to the cluster tool, according to length of a bottle neck process step or a transferring movement. The method further comprises checking resource conflicts in the determined schedule using the determined fundamental period and removing any resource conflicts by adding queue time to the schedule and/or extending the fundamental period.

Resource conflicts are detected and removed by reducing the problem to a periodic system and solving a set of equations within a time interval of (0, T), wherein T denotes a predetermined fundamental period. In one embodiment, a game tree algorithm is used to resolve resource conflicts. In one embodiment, an efficient method of game tree trimming is used to find a first feasible solution.

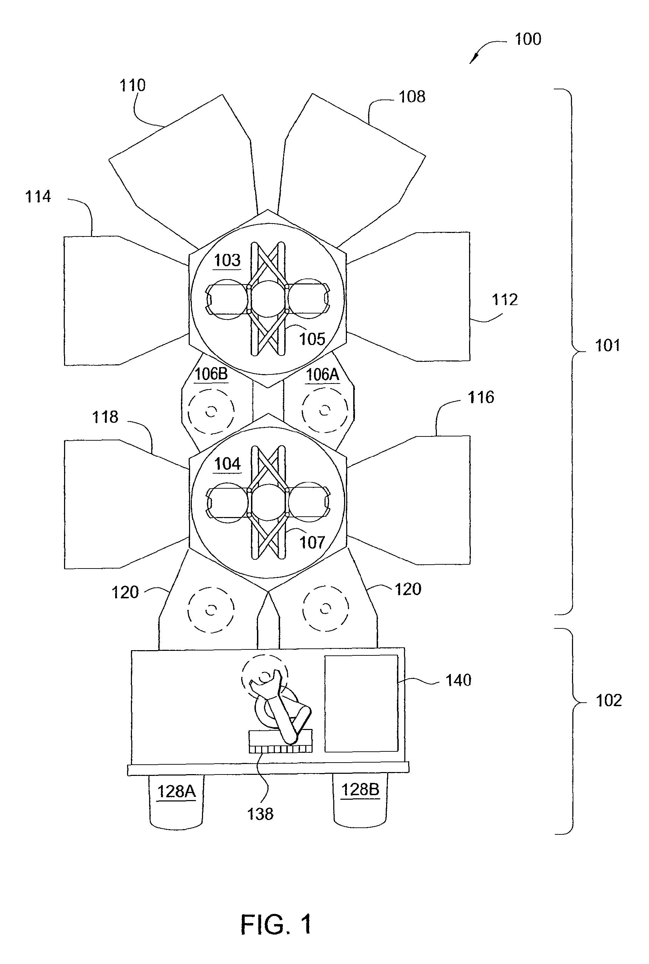

Embodiments of the present invention are described herein in accordance with a poly silicon generating sequence. Figure 1 schematically illustrates a cluster tool 100 for semiconductor processing in accordance with one embodiment of the present invention. It is contemplated that the methods described herein may be practiced in other tools configured to perform a process sequence.

The cluster tool 100 includes a vacuum-tight processing platform 101 and a factory interface 102. The platform 101 comprises a plurality of processing chambers 110, 108, 114, 112, 118, 116, and at least one load-lock chamber 120, which are coupled to vacuum substrate transfer chambers 103, 104. The factory interface 102 is coupled to the transfer chamber 104 by the load lock chamber 120.

In one embodiment, the factory interface 102 comprises at least one docking station, at least one substrate transfer robot 138, and at least one substrate aligner 140. The docking station is configured to accept one or more front opening unified pod 128 (FOUP). Two FOUPs 128A, 128B are shown in the embodiment of Figure 1. The substrate transfer robot 138 is configured to transfer the substrate from the factory interface 102 to the load lock chamber 120.

The load lock chamber 120 has a first port coupled to the factory interface 102 and a second port coupled to a first transfer chamber 104. The load lock chamber 120 is coupled to a pressure control system which pumps down and vents the chamber 120 as needed to facilitate passing the substrate between the vacuum environment of the transfer chamber 104 and the substantially ambient (e.g., atmospheric) environment of the factory interface 102.

The first transfer chamber 104 and the second transfer chamber 103 respectively have a first robot 107 and a second robot 105 disposed therein. Two substrate transfer platforms 106A, 106B are disposed in the transfer chamber 104 to facilitate transfer of the substrate between robots 105, 107. The platforms 106A, 106B can either be open to the transfer chambers 103, 104 or be selectively isolated (i.e., sealed) from the transfer chambers 103, 104 to allow different operational pressures to be maintained in each of the transfer chambers 103, 104.

The robot 107 disposed in the first transfer chamber 104 is capable of transferring substrates between the load lock chamber 120, the processing chambers 116, 118 and the substrate transfer platforms 106A, 106B. The robot 105 disposed in the second transfer chamber 103 is capable of transferring substrates between the substrate transfer platforms 106A, 106B and the processing chambers 112, 114, 110, 108.

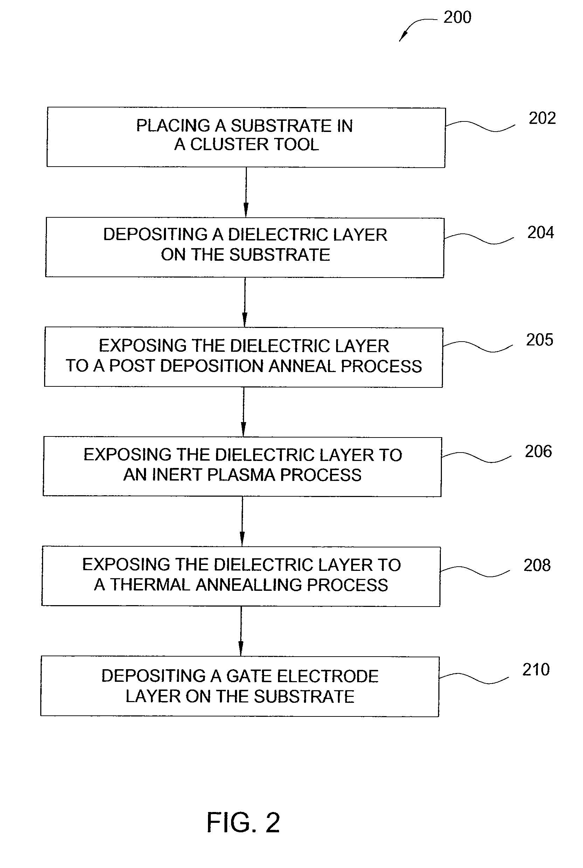

Figure 2 illustrates a flow chart of one embodiment of a process sequence 200 for deposition dielectric layers on the substrate in an integrated cluster tool, such as the cluster tool 100 described above.

The process sequence 200 begins at step 202 with positioning a substrate in a cluster tool.

At step 204, a dielectric layer is deposited on the substrate. The dielectric layer may be a metal oxide, and may be deposited by an ALD process, a MOCVD process, a conventional CVD process or a PVD process.

Subsequent the deposition process, the substrate may be exposed to a post deposition anneal (PDA) process at step 205. The PDA process may be performed in a rapid annealing chamber, such as the RADIANCE™ RTP chamber.

In step 206, the dielectric layer is exposed to an inert plasma process to densify the dielectric material and forming plasma-treated layer. The inert plasma process may include a decoupled inert gas plasma process performed by flowing an inert gas into a decoupled plasma nitridation (DPN) chamber.

At step 208, the plasma-treated layer disposed on the substrate is exposed to a thermal annealing process.

In step 210, a gate electrode layer is deposited over the annealed dielectric layer. The gate electrode layer may be a polycrystalline-Si, amorphous-Si or other suitable material deposited by using a LPCVD chamber.

Table 1 illustrates recipe time and chamber requirement for each steps in the sequence 200.

Table 1: A process sequence

| STEP | CHAMBER | RECIPE TIME (SECONDS) |
|------|---------|----------------------|
| 202 | ALIGNER | 5 |
| 204 | DPN+(A) | 100 |
| 205 | RTO | 200 |
| 206 | COOL DOWN | 120 |
| 207 | DPN+(B) | 100 |
| 208 | PNA | 180 |
| 210 | POLY GENERATION | 150 |

Methods of present invention relate to determining a process schedule that achieves substrate consistency, stays within resource constraints and maximizes throughput.

A process schedule of the present invention may include a schedule for an individual substrate (hereafter **individual schedule**) and a **fundamental period** between sequential substrates. An individual schedule includes start time and end time for each process step of a substrate relative to the start time for the first move of the substrate. A fundamental period defines a rate at which substrates are sent to a cluster tool. Particularly, a fundamental period is the time interval between two sequential substrates.

Factors affect a process schedule may include the process sequence to be performed, time taken to execute each recipe step, substrate queue time constraints at each step, and transfer times between different chambers. Substrate queue time constraint is typically part of the sequence defines the maximum amount of time a substrate is allowed to wait in a given chamber for a given process step after a process recipe is completed. Table 2 illustrates an exemplary substrate queue time constraints for related chambers may be used to perform process sequence 200. Time taken to execute each recipe step generally includes timing information about the process, cleaning and periodic cleaning process. For simple time based recipe, time taken to execute each recipe step may be calculated by parsing the recipes steps. For end point based recipes, statistical information, such as average time taken, may be used for creating schedule. The transfer time is actual robot movement times and some overheads that may be related to any other recipes that are executed as a part of the transferring itself.

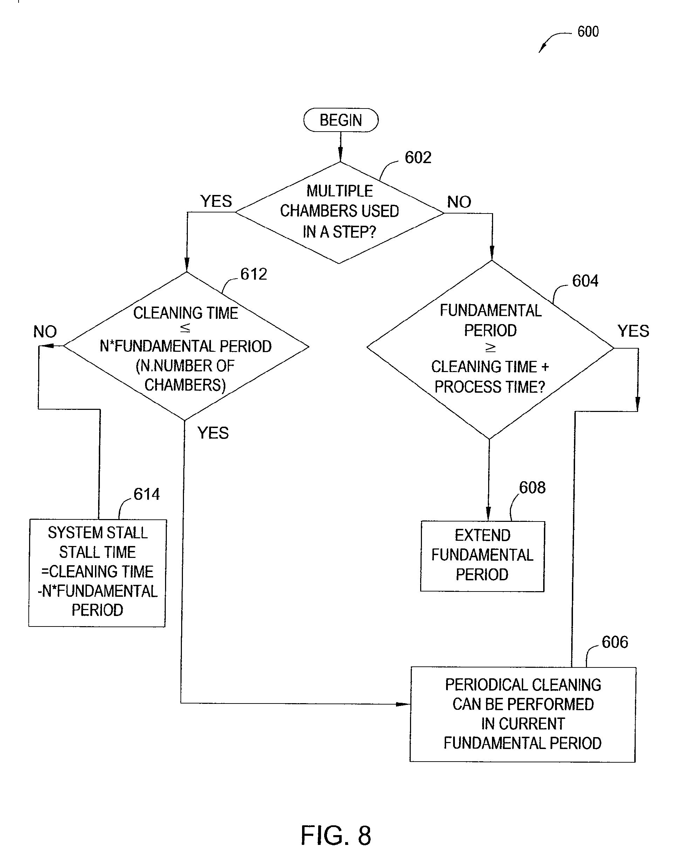

Referring to Table 2, total recipe time range indicates a time range for processing a substrate in a corresponding chamber according to a given process sequence, in this case the process sequence 200. Queue time sensitivity indicates the maximum waiting period a substrate may have in a corresponding chamber after a process step is completed in the chamber. Substrate handling variation limit indicates a maximum variation of queue time from substrate to substrate in order to obtain desired process consistency. Clean frequency indicates how often a corresponding needs to be cleaned. Clean time relates to time needed to complete a cleaning process. For chambers that require periodical cleaning, the cleaning process may be dealt with according to the frequency and length of the cleaning requirement. For chambers that require to be cleaned after every substrate, such as DPN+(A) and DPN+(B), cleaning time is generally added to the process time. Additional cleaning consideration is described in Figure 8.

Table 2: Queue time constraints

| CHAMBER | Total Time Recipe (sec) Range | Queue Time Sensitivity (sec) | Substrate Handling Variation Limit (sec) | Clean Frequency (substrates) | Clean Time (sec) |
|---|---|---|---|---|---|
| DPN+(A) | 40 - 120 | 4 hrs | - | 1 | 35 |
| RTO | 120 - 240 | 30 | <5 | - | 0 |
| COOLDOWN | 120 | 30 | 30 | - | 0 |
| DPN+(B) | 60 - 120 | 30 | 30 | 1 | 35 |
| PNA | 120 - 240 | 30 | <5 | - | 0 |
| POLY GEN | 120 - 180 | 60 | 30 | 100 | 5400 |

In one embodiment of the present invention, a process schedule of the present invention may be determined by the following steps: assigning resources for performing a given process sequence and determining an initial individual schedule, determining an initial fundamental period, checking resource conflicts for the initial individual schedule and the initial fundamental period, and removing resource conflicts by adding substrate queue time to the individual schedule. In one embodiment of the present invention, determining a process schedule may comprises extending the initial fundamental period to remove resource conflicts.

**Assigning resources and determining initial individual schedule**

Assigning resources generally comprises setting up chamber arrangement for a cluster tool, and allocating robots for transferring substrates among arranged chambers.

Chamber arrangement may include defining chamber positions and number of chambers for a process step. Chamber arrangement may be affected by the process sequence to be performed, time taken to execute each recipe step, substrate queue time constraints at each step.

For example, the cluster tool 100 may be configured to perform the process sequence 200. Suitable chambers may be chosen for chambers 108, 110, 112, 114, 116, 118 to facilitate the process sequence 200. For example, the chambers 116, 118 may be chemical vapor deposition (CVD) chamber configured to deposition poly crystalline silicon (POLY). One suitable chamber is a POLYGen chamber, available from Applied Materials, Inc. The chambers 108, 114 may be Decoupled Plasma Nitridation (DPN) chamber. The chambers 110, 112 may be Rapid Thermal Process (RTP) chamber. One or more cool down chambers may be positioned above the substrate transfer platform 106A, 106B.

Upon determining the arrangement of the chambers in the cluster tool 100, resources, including chambers, load locks, and robots, may be allocated for each process step and transition between steps.

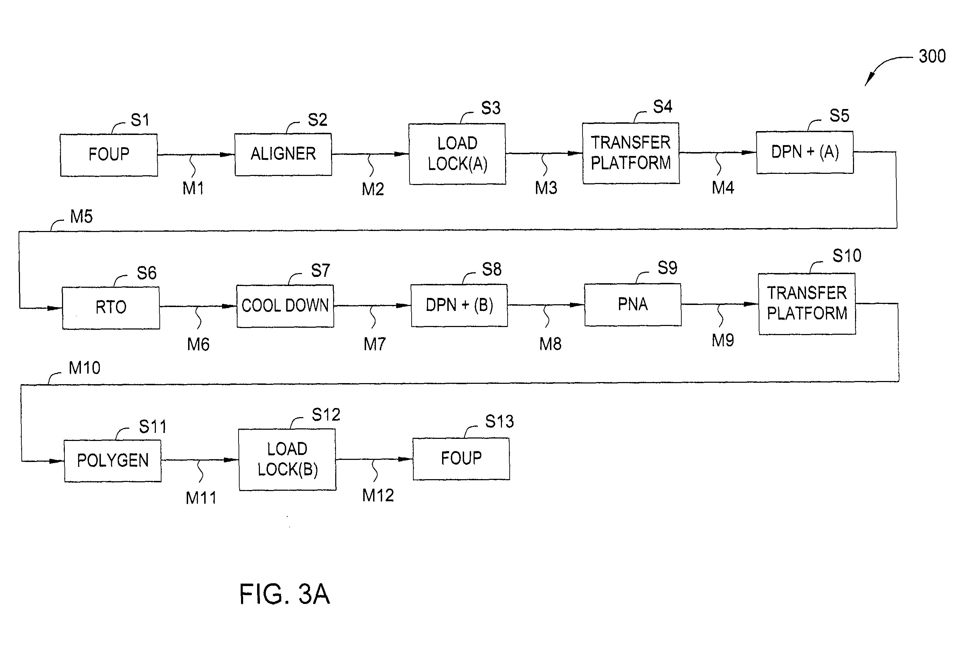

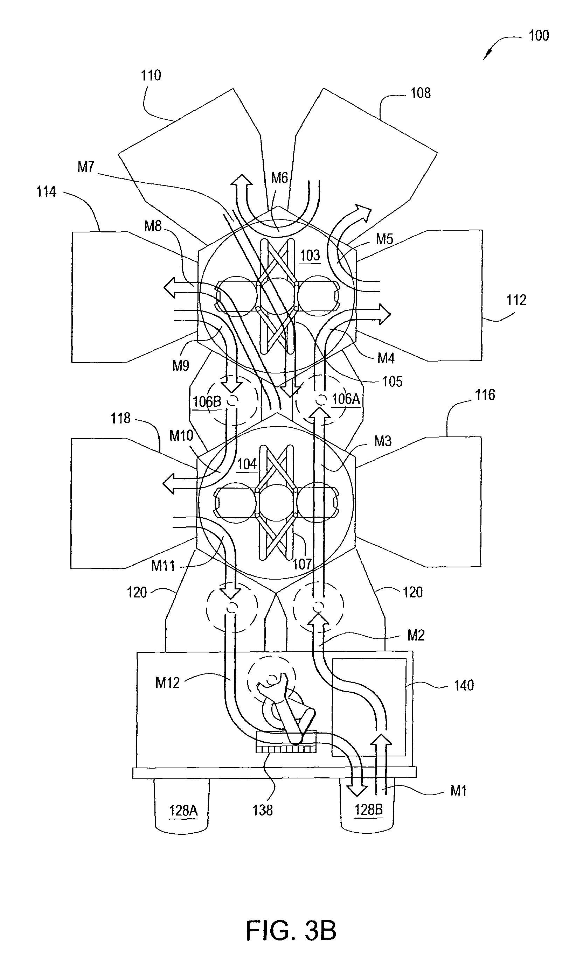

Figure 3A schematically illustrates a flow chart of an exemplary process sequence in accordance with one embodiment of the present invention. Figure 3B schematically illustrates a route of substrates processed in the process sequence of Figure 3A in the cluster tool 100 of Figure 1. Referring Figure 3A, steps S1-S13 represent a substrate staying in a process chamber, a transfer chamber or a load lock. Moves m1-m12 represent a substrate's movement from between chambers carried by a robot. The moves m1-m12 are further illustrates in arrows of Figure 3B.

Table 3 illustrates an individual schedule for the process sequence 200. Process time indicates the total time duration a substrate occupies a resource, chambers or robots. Starts marks the time a substrate starts occupying a resource relative to the substrate first enters the cluster tool. Ends marks the time the substrate releasing the resource relative to the substrate enters the cluster tool. There is no queue time added to any steps in the initial individual schedule. A substrate may be able to follow this schedule when no other substrates are in the cluster tool. As shown in Table 3, it takes 1233 seconds for a substrate to complete the process sequence 200. When only one substrate is in a cluster tool, there are only up to two resources being occupied at any given time while the rest of the resources are idle. To reduce idle time and increase throughput, a second substrate may be fed into the cluster tool before a first substrate exits the cluster tool. The time duration between sending two substrates, i.e. fundamental period, may be minimized to maximize the throughput.

Table 3: An initial individual schedule

| Step/Move | Chamber/Robot | Process Time (sec) | Starts (sec) | Ends (sec) |
|---|---|---|---|---|
| S1 | FOUP | 0 | 0 | 0 |
| M1 | FI Robot | 22 | 0 | 22 |
| S2 | ALIGNER | 5 | 22 | 27 |
| M2 | FI Robot | 22 | 27 | 49 |
| S3 | LOAD LOCK (A) | 20 | 49 | 69 |
| M3 | Front Robot | 26 | 69 | 95 |
| S4 | TRANSFER PLATFORM | 0 | 95 | 95 |
| M4 | Rear Robot | 20 | 95 | 115 |
| S5 | DPN+(A) | 135 (cleaning included) | 115 | 250 |
| M5 | Rear Robot | 20 | 250 | 270 |
| S6 | RTO | 200 | 270 | 470 |
| M6 | Rear Robot | 20 | 470 | 490 |
| S7 | COOL DOWN | 120 | 490 | 610 |
| M7 | Rear Robot | 20 | 610 | 630 |
| S8 | DPN+(B) | 135 (cleaning included) | 630 | 765 |
| M8 | Rear Robot | 20 | 765 | 785 |
| S9 | PNA | 180 | 785 | 965 |
| M9 | Rear Robot | 20 | 965 | 985 |
| S10 | TRANSFER PLATFORM | 0 | 985 | 985 |
| M10 | Front Robot | 20 | 985 | 1005 |
| S11 | POLY GENERATION | 150 | 1005 | 1155 |
| M11 | Front Robot | 30 | 1155 | 1185 |
| S12 | LOAD LOCK (B) | 30 | 1185 | 1215 |

(continued)

| Step/Move | Chamber/Robot | Process Time (sec) | Starts (sec) | Ends (sec) |
|-----------|---------------|--------------------|--------------|------------|
| M12 | FI Robot | 18 | 1215 | 1233 |
| S13 | FOUP | 0 | 1233 | 1233 |

**Determining an initial fundamental period**

In one embodiment of the present invention, an initial fundamental period may be determined according to the longest busy duration among all resources in a cluster tool. Busy duration of a resource may be defined by the total time taken to perform all the steps/moves in a process sequence for a signal substrate.

In one embodiment, the busy duration for each resource may be calculated by iterating through all process steps in a process sequence and breaking each process step into sub-parts including load time, unload time, process recipe time and cleaning time. Each of the sub-parts is then assigned to a resource (or resources) required for the sub-parts.

For a chamber, busy duration may include loading time, process recipe time, unloading time, and cleaning time if required for all the steps the chamber are used in a process sequence. When at least two chambers are arranged to perform one step, busy duration may be divided by the number of the chambers. In one embodiment, busy duration for a chamber may be calculated using the following formula,

$$D[i] = \sum_{k=1}^{K} (P[k] + L[k] + U[k] + C[k]) / n$$

wherein $D[i]$ denotes busy duration for chamber $i$, $k$ denotes process steps where chamber $i$ are used, $P[k]$ denotes process time of step $k$, $L[k]$ denotes loading time of step $k$, $U[k]$ denotes unloading time of step $k$, $C[k]$ denotes cleaning time of step $k$, and $n$ denotes number of chamber $i$. The summation is over all the steps executed in chamber $i$.

For a robot, busy duration may include pickup time, transfer time and drop time of all the moves the robot are used. In one embodiment, busy duration for a robot may be calculated using the following formula,

$$D[j] = \sum_{l=1}^{L} (Pk[l] + Tr[l] + Dr[l])$$

wherein $D[j]$ denotes busy duration for robot $j$, $l$ denotes moves where robot $j$ are used, $Pk[l]$ denotes pick up time of move $l$, $Tr[l]$ denotes transfer time of move $l$, and $Dr[l]$ denotes drop time of move $l$. The summation is over all the moves executed by robot $j$.

In one embodiment, an initial fundamental period may be set to the maximum busy duration of all resources, including chambers and robots.

Generally, pickup time of a move for a robot overlaps unloading time of a previous step, and drop time of a move for a robot overlaps loading time of a subsequent step. Accordingly, loading time of a step for a chamber overlaps drop time of a previous move and unloading time of a step for chamber overlaps pickup time of a subsequent move. To simplify the calculation of duration time for chambers, a chamber busy duration may include time needed for a previous move, time needed for a subsequent move, process time, and cleaning time if required. Table 4 lists calculated busy duration for resources of the cluster tool 100 for performing the process sequence 200. As shown in Table 4, the longest busy duration is 240 seconds, which belongs to the RTO chamber. Accordingly, an initial fundamental period may be set to 240 seconds in accordance with one embodiment of the present invention.

Table 4: Fundamental period Calculation

| Resources | Number | Busy Duration | Calculation |
|-----------|--------|---------------|-------------|
| FOUP | 1 | 40 | M1+M12 |
| ALIGNER | 1 | 47 | S2+M1+M2 |

(continued)

| Resources | Number | Busy Duration | Calculation |
|---|---|---|---|
| LOAD LOCK (A) | 2 | 73 | (S3+M2+M3+S12+M11+M12)/2 |
| TRANSFER PLATFORM | 2 | 34 | (S4+M3+M4)/2 |
| DPN+(A) | 1 | 175 | S5+M4+M5 |
| RTO | 1 | **240** | S6+M5+M6 |
| COOL DOWN | 2 | 80 | (S7+M6+M7)/2 |
| DPN+(B) | 1 | 175 | S8+M7+M8 |
| PNA | 1 | 220 | S9+M8+M9 |
| POLY GENERATION | 2 | 100 | (S11+M10+M11)/2 |
| LOAD LOCK (B) | 2 | 39 | (S12+M11+M12)/2 |
| FI Robot | 1 | 62 | M1+M2+M12 |
| Front Robot | 1 | 76 | M3+M10+M11 |
| Rear Robot | 1 | 120 | M4+M5+M6+M7+M8+M9 |

**Checking resource conflicts**

Resource conflicts refer to situations when one resource is required by more than one step or move at the same time. Resource conflicts may generate when there are more than one substrate in a cluster tool and when one or more resources are used in more than one step or move. Generally, robot conflicts are common since robots are usually used for multiple moves in a process schedule. But resource conflicts could happen to process chambers, load locks, and or transfer chambers when those resources are scheduled in more than one step in a process sequence.

In one embodiment of the present invention, resource conflicts corresponding to a given individual schedule and a fundamental period may be checked by calculating relative start time and relative end time for each step/move in a period.

In one embodiment, relative start time $S_{Relative}[i, N]$ and relative end time $E_{Relative}[i, N]$ of step $i$ of Nth substrate may be calculated by

$$S_{relative}[i,N] = S[i,N] \bmod FP$$

$$E_{relative}[i,N] = E[i,N] \bmod FP$$

wherein $i$ denotes step/move number, $N$ denotes substrate sequence number, $FP$ denotes fundamental period, $S[i, N]$ denotes absolute start time of step i of the Nth substrate, and $E[i, N]$ denotes absolute end time of step i of the Nth substrate. $S[i, N]$ and $E[i, N]$ may be calculated by equations below,

$$S[i,N] = (N-1) \times FP + \sum_{k=0}^{i-1} D[k]$$

$$E[i,N] = S[i,N] + D[i]$$

wherein $i$ denotes step/move number, $N$ denotes substrate sequence number, $FP$ denotes fundamental period, $D[i]$ denotes busy duration of $i$th step/move.

In one embodiment, resource conflicts may be detected by detecting overlaps of intervals of relative start time and relative end time for different steps/moves. For example, if steps i and k require the same resource, overlap of intervals ($S_{Relative}[i, N]$, $E_{Relative}[i,N]$) and ($S_{Relative}[K,N]$, $E_{Relative}[k, N]$) indicates a resource conflict.

Table 5 lists an exemplary resource conflict results for the initial individual schedule of Table 4 for a fundamental period of 240 seconds. As shown in Table 5, M9 of rear robot conflicts with M5 and M6, and M12 of FI robot conflicts with M1 and M2.

Table 5: Resource Conflict for a Given Fundamental period (Fundamental period = 240)

| Step/ Move | Chamber/ Robot | Start | End | Queue Time | Relative Start | Relative End | Conflict |
|---|---|---|---|---|---|---|---|
| S1 | FOUP | 0 | 0 | 0 | 0 | 0 | |
| M1 | FI Robot | 0 | 22 | | 0 | 22 | |
| S2 | ALIGNER | 22 | 27 | 0 | 22 | 27 | |
| M2 | FI Robot | 27 | 49 | | 27 | 49 | |
| S3 | LOADLOCK (A) | 49 | 69 | 0 | 49 | 69 | |
| M3 | Front Robot | 69 | 95 | | 69 | 95 | |
| S4 | TRANSFER PLATFORM | 95 | 95 | 0 | 95 | 95 | |
| M4 | Rear Robot | 95 | 115 | | 95 | 115 | |
| S5 | DPN+(A) | 115 | 250 | 0 | 115 | 10 | |
| M5 | Rear Robot | 250 | 270 | | 10 | 30 | |
| S6 | RTO | 270 | 470 | 0 | 30 | 230 | |
| M6 | Rear Robot | 470 | 490 | | 230 | 10 | |
| S7 | COOL DOWN | 490 | 610 | 0 | 10 | 130 | |
| M7 | Rear Robot | 610 | 630 | | 130 | 150 | |
| S8 | DPN+(B) | 630 | 765 | 0 | 150 | 45 | |
| M8 | Rear Robot | 765 | 785 | | 45 | 65 | |
| S9 | PNA | 785 | 965 | 0 | 65 | 5 | |
| M9 | Rear Robot | 965 | 985 | | 5 | 25 | M5 of 3rd, M6 of 4th |
| S10 | TRANSFER PLATFORM | 985 | 985 | 0 | 25 | 25 | |
| M10 | Front Robot | 985 | 1005 | | 25 | 45 | |
| S11 | POLY GENERATION | 1005 | 1155 | 0 | 45 | 195 | |
| M11 | Front Robot | 1155 | 1185 | | 195 | 225 | |
| S12 | LOAD LOCK (B) | 1185 | 1215 | 0 | 225 | 15 | |
| M12 | FI Robot | 1215 | 1233 | | 15 | 33 | M1 of 5th, M2 of 5th, |
| S13 | FOUP | 1233 | 1233 | 0 | 33 | 33 | |

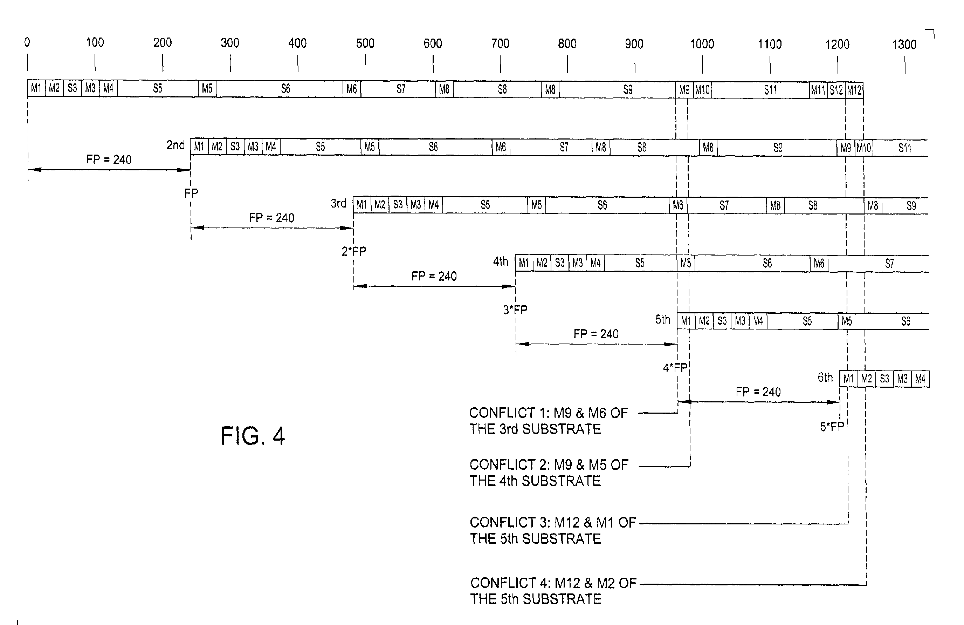

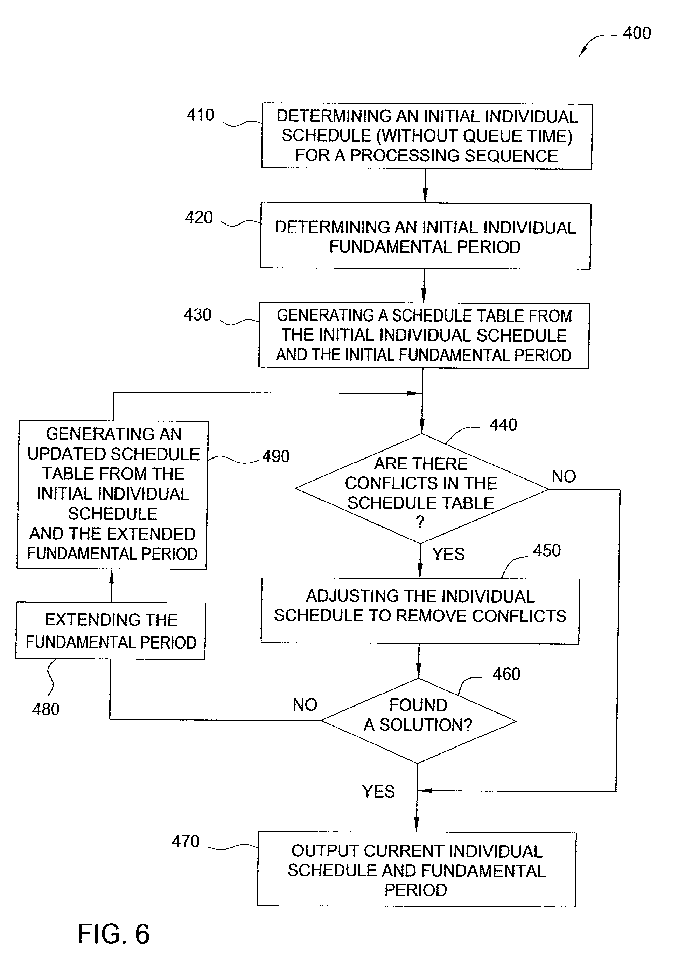

Figure 4 schematically illustrates a recipe diagram for a schedule table of table 5. As shown in Figure 4, 6 substrates are processed in the system. Each substrate is sent to the system at a fundamental period apart. M9 of the first substrate and M6 of the third substrate require the rear robot at one time causing conflict 1. M9 of the first substrate and M5 of the fifth substrate require the rear robot at one time causing conflict 2. M12 of the first substrate and M1 of the fifth substrate require the FI robot at one time causing conflict 3. M12 of the first substrate and M2 of the fifth substrate require the FI robot at one time causing conflict 4.

**Removing resource conflicts**

In one embodiment of the present invention, a resource conflict may be removed by adding a queue time to delay one of the two steps involved in the conflict. In one embodiment, a queue time may be added to delay a later step of the two conflicting steps.

As shown in Table 6, conflicts of the rear robot between M9 and M5, and M9 and M6 are removed by adding a queue time of 25 seconds to step S9. M9 is delayed by 25 seconds and each substrate is scheduled to stay in the system for 1258 seconds, compared to 1233 second prior to the queue time. However, since the fundamental period remains 240 seconds, the system throughput is not reduced because of the delay.

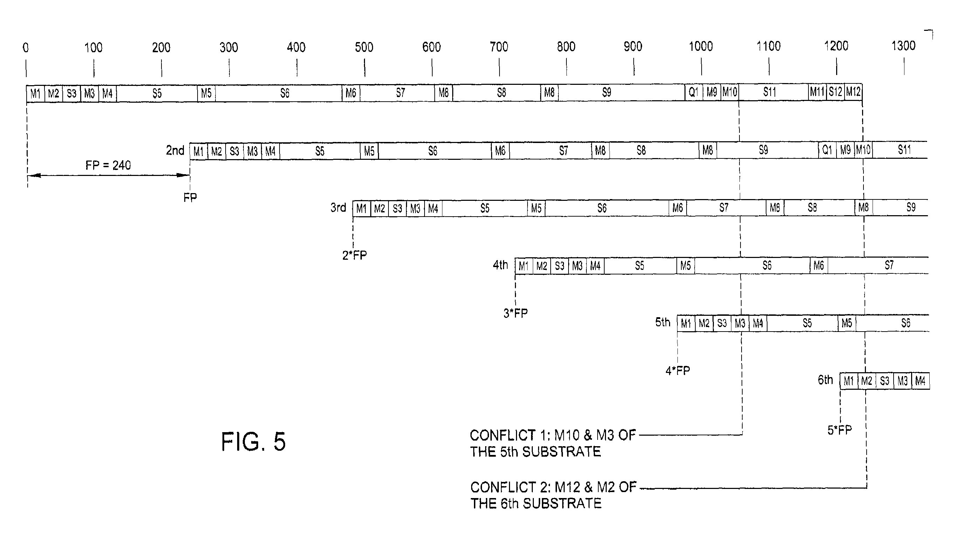

Figure 5 schematically illustrates a recipe diagram for the updated schedule table listed in Table 6.

Table 6: Schedule Table after Adding a Queue Time

| Step/ Move | Chamber/Robot | Start | End | Queue Time | Relative Start | Relative End | Conflict |
|---|---|---|---|---|---|---|---|
| S1 | FOUP | 0 | 0 | 0 | 0 | 0 | |
| M1 | FI Robot | 0 | 22 | | 0 | 22 | |
| S2 | ALIGNER | 22 | 27 | 0 | 22 | 27 | |
| M2 | FI Robot | 27 | 49 | | 27 | 49 | |
| S3 | LOADLOCK (A) | 49 | 69 | 0 | 49 | 69 | |
| M3 | Front Robot | 69 | 95 | | 69 | 95 | |
| S4 | TRANSFER PLATFORM | 95 | 95 | 0 | 95 | 95 | |
| M4 | Rear Robot | 95 | 115 | | 95 | 115 | |
| S5 | DPN+(A) | 115 | 250 | 0 | 115 | 10 | |
| M5 | Rear Robot | 250 | 270 | | 10 | 30 | |
| S6 | RTO | 270 | 470 | 0 | 30 | 230 | |
| M6 | Rear Robot | 470 | 490 | | 230 | 10 | |
| S7 | COOL DOWN | 490 | 610 | 0 | 10 | 130 | |
| M7 | Rear Robot | 610 | 630 | | 130 | 150 | |
| S8 | DPN+(B) | 630 | 765 | 0 | 150 | 45 | |
| M8 | Rear Robot | 765 | 785 | | 45 | 65 | |
| S9 | PNA | 785 | 965 | 25 | 65 | 30 | |
| M9 | Rear Robot | 990 | 1010 | | 30 | 50 | |
| S10 | TRANSFER PLATFORM | 1010 | 1010 | 0 | 50 | 50 | |
| M10 | Front Robot | 1010 | 1030 | | 50 | 70 | M3 of 5th, |
| S11 | POLY GENERATION | 1030 | 1180 | 0 | 70 | 220 | |
| M11 | Front Robot | 1180 | 1210 | | 220 | 10 | |
| S12 | LOAD LOCK(B) | 1210 | 1240 | 0 | 10 | 40 | |
| M12 | FI Robot | 1240 | 1258 | | 40 | 58 | M2 of 5th, |
| S13 | FOUP | 1258 | 1258 | 0 | 58 | 58 | |

Sometimes, new resource conflicts may be created from added queue. As shown in Figure 5, new conflicts between M10 and M3, and between M12 and M2 are generated as a result of the added queue time. In one embodiment of the present invention, an updated schedule table may be generated, resource conflicts may be checked for the updated schedule table, and additional queue time may be introduced to remove new conflicts after an added queue time. In one embodiment, queue times may be added to the individual schedule until there is no resource conflict. However, in some cases, resource conflicts may not be removed by adding queue time or the queue time added may be outside queue time sensitivity constraints of the resources (such as the constraints shown in Table 2). In case resource conflicts cannot be removed by adding queue time to processing steps, the fundamental period may be extended and resource conflicts may be checked and removed for the initial individual schedule based on the extended fundamental period.

Figure 6 illustrates a flow chart of a scheduling method 400 in accordance with one embodiment of the present invention. The scheduling method 400 is configured to find a schedule for a process sequence. The schedule ensures a maximal throughput with consistency between substrates and observing constraints of resources, such as queue time sensitivity. The result schedule of the scheduling method 400 comprises an individual schedule and a fundamental period, wherein the individual schedule indicates an individual substrate's time table in a cluster tool during the whole process sequence and the fundamental period indicates a time interval between start times of two sequential substrates. An exemplary schedule is shown in Table 3.

In step 410 of the scheduling method 400, an initial individual schedule may be determined for a process sequence. The initial individual schedule comprises a time table of a substrate in a cluster tool with no waiting time in any steps and moves. The initial individual schedule is generally determined according to the process sequences, the topology of the cluster tool where the substrates are to be processed.

In step 420, an initial fundamental period may be determined. In one embodiment, the initial fundamental period is set to be the busy duration of a bottle neck resource, such as a chamber or a robot. Embodiments for calculating the busy duration is described above. Setting the initial fundamental period to be the busy duration of the bottle neck resource ensures the search of a possible schedule starts from the highest throughput.

In step 430, a schedule table may be generated based on the initial individual schedule and the initial fundamental period. In one embodiment, the schedule table may include, for each resource, a time table within a fundamental period. For example, in the schedule table related to Table 4, within each fundamental period (0, 240), the FI Robot needs to perform M1 during (0, 22), M2 during (27, 49) and M12 during (15, 33).

In step 430, resource conflicts are checked out for the generated schedule table. In one embodiment, resource conflicts may be determined by checking overlaps in the time table of every resource with in a fundamental period. For example, the time table of FI Robot in table 4 has overlaps between M1/M12 and M2/M12. In one embodiment, resource conflicts check may be performed for any resources that are required by at least two steps and/or moves during the process sequence.

If no resource conflicts are found in a schedule table for all the resources in the cluster tool, the individual schedule and the fundamental period relate to the schedule table is acceptable solution for the problem, and the method jumps to step 470 to output the current individual schedule and fundamental period for process.

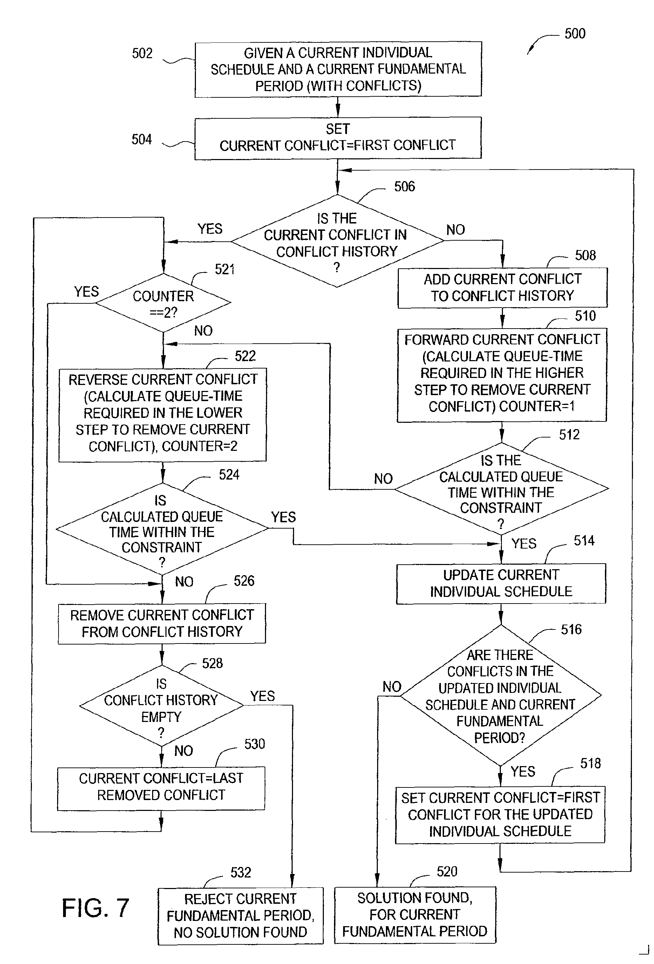

In case there are resource conflicts in the schedule table, the resource conflicts may be removed by adjusting the individual schedule in step 450. In one embodiment, resource conflicts may be removed by adding queue time to the individual schedule. In one embodiment, queue time may be added to delay one of the steps that causing a resource conflict. In one embodiment, a game tree algorithm may be used to remove resource conflicts. In one embodiment, resource constraints are considered when adding a queue time to the individual schedule. A detailed method for removing resource conflicts is described in accordance with Figure 7.

Step 450 outputs a result. In step 460, output from step 450 is examined. If resource conflicts are removed by adjusting the individual schedule, the scheduling method jumps to step 470 and outputs the updated individual schedule and the current fundamental period. However, if resource conflicts cannot be removed by adjusting the individual schedule, the scheduling method goes on to step 480.

In step 480, the current fundamental period is extended. In one embodiment, the fundamental period may be extended in a predetermined increment. By extending the fundamental period, the scheduling method searches a possible resolution in a domain with a lowered throughput.

In step 490, an updated schedule table is generated from the extended fundamental period and the initial individual schedule wherein no queue time is added. The scheduling method then goes to step 440 checking for resource conflicts.

As such, the scheduling method 400 provides a schedule with substrate to substrate consistency and maximized throughput for a given process sequence.

**Game Tree Algorithm**

In one embodiment of the present invention, game tree algorithm may be used in a scheduler, such as the scheduling method 400, to remove conflicts in a schedule table.

The concept of the game tree is used in gaming theory to determine the best possible move a system can make to win a given game. A game tree is a directed acyclic graph where each node in the acyclic graph is a state of the system, for example an individual schedule and a fundamental period, and each edge represents a move, for example a change to an individual schedule or a fundamental period. A pair of nodes and an edge connecting the pair of nodes can be viewed as a differential change that happens in the system when a move is executed. At each step of the game the best possible move is chosen by searching the game tree.

A game tree may be viewed as a data structure used to solve combinatorial problems. In this particular case of scheduling, the conflicts of resources, such as robots, can be resolved by rearranging the start time and end time of a step when two or more steps overlap. The next move the system should make towards a solution may be chosen the best order of re-arrangement to minimize resource conflicts. However since the algorithm is of factorial order, the computational resource needed is very large when large number of moves are to be considered. Hence an efficient way of reducing the number of possibilities to consider is necessary to make this solution feasible. To reduce the number of possibilities to consider is called trimming the game tree. In one embodiment of the present invention, trimming the tree may be achieved by using maximum queue time constraints to eliminate a large number of possibilities. A maximum queue time constraint may be a predetermined time and given with a target process sequence. A maximum queue time may also be chosen by the scheduler based on a fundamental period if not predetermined. For any given resource, maximum queue time may be chosen using the following equation:

$$\text{Max Queue Time} = \text{Minimum of (busy duration of bottle-neck resource - (busy duration of the resource of interest), User define value in the sequence).}$$

In one embodiment of the present invention, a game tree is used to find the first feasible solution. By choosing the first feasible solution, instead of the best solution, the problem is greatly simplified. The goal of the scheduler is to maximize the throughput. Once a fundamental period has been set, the throughput value cannot be changed by adding queue time to each step because the added queue time does not change a bottle-neck duration since the queue time is constrained by the maximum queue time equation shown above. Therefore, the problem of resolving resource conflicts is orthogonal to maximizing the throughput. The best solution, if it was searched for, would be a solution that minimizes the queue time required at each step. But that will only lead to a very small amount of gain for long running production batches. So in the interest of efficiency, the first feasible solution, when found, determines the end of the search.

With the above mentioned simplification the algorithm does not need to build the complete search tree. Method of the present invention starts to build a search tree, rejects some branches which violate the maximum queue time constraint or if the branch leads to a cyclic dependency, i.e. recurring resource conflicts. When the first branch of the search tree which resolves all the conflict is found, the algorithm ends and uses it as the solution.

The game tree in accordance with the present invention may be created in depth first manner. The scheduler iterates through all processing steps/moves and assigns resources for execution of each step/move. In cases where multiple resources are available to execute a step, the scheduler multiplexes between the available resources to achieve a uniform load distribution. After assigning a resource, the scheduler checks if there is any resource conflict. To identify recurring resource conflicts, the scheduler also maintains the history of all the resource conflicts it has resolved. Before delaying any step, the scheduler consults the conflict history table to see if the same resource conflict has been solved in the past. If a resource conflict has been solved in the past, the scheduler rejects the change and tries to find another feasible solution. In order to trim the game tree, the calculated delay is compared with the maximum queue time constraints for the given step. The step is only delayed if the constraint conditions are not violated.

To solve a resource conflict between steps I and K, the scheduler has two ways to remove this resource conflict, i.e. delaying step I and delaying step K. The two solutions lead to two different branches in the game tree. In one embodiment of the present invention, the scheduler first tries to delay the step which has higher relative start time. If step K has higher relative start time than step I, the scheduler tries to add a queue time to delay step K first. If the conflict history table does not have the same conflict and the maximum queue time constraints are satisfied, a new child node is created and scheduler table is adjusted to reflect the new delay in step K. It should be noted that if step K is delayed by $\Delta$ seconds, start times of all the steps following step K, which are step K+1 to step N (where N is the total number of steps) are also increased by the same $\Delta$.

After resolving a resource conflict, the scheduler searches resource conflicts in the updated schedule table after the queue time is added. Resource conflicts may be created because of the delay introduced to remove a resource conflict or may be pre-existing.

If the step K cannot be delayed because of any constraint violation, the scheduler moves to the next branch by trying to delay the step I. This may be referred as conflict reversal. If both the possibilities, delaying step K and delaying step I, are rejected, the scheduler moves up the game tree and reverses the conflict of the parent node. Since each resource conflict can be resolved in exactly two ways, a count of number of attempts to resolve the conflict may be used. If the count exceeds two, then there is no solution at the current node and the scheduler move up the game tree to try and reverse other conflicts in the branch.

When all the steps have been assigned a resource and there are no conflicts, the solution is accepted and the delays at each step are used by the scheduler.

In some cases, there is no solution to the set of resource conflicts. The game tree method returns no solution and the scheduler then increases the fundamental period by a small delta and recreates the relative times in the scheduler table using the extended fundamental period.

Figure 7 illustrates a flow chart of a method 500 for removing resource conflicts in accordance with one embodiment of the present invention. The Method 500 is configured to search a first feasible solution to remove a resource conflicts for a given process sequence and a give fundamental period. The game tree theory discussed above is used in the method 500. The method 500 may be used in step 450 of the scheduling method 400 of Figure 6.

In step 502, a schedule based on an individual schedule and a fundamental period is provided. The schedule has resource conflicts. In one embodiment, resource conflicts may be detected from the schedule.

In step 504, current conflict, the resource conflict to be removed, is set to the first resource conflict of the schedule. In one embodiment, the first resource conflict is defined by a first conflict encounter in a time table of the individual schedule. For example, conflict 1 in Figure 4.

In step 506, a conflict history may be searched to check if the current conflict has been solved before.

If the current conflict is not in the conflict history, the current conflict is added to the conflict history in step 508.

In step 510, a first solution to remove the current conflict is attempted. Step 510 may include calculation a queue time required to delay the step with higher start time in order to remove the current conflict. In one embodiment, a counter relates to the current conflict is set to 1 to mark the times of attempts made to resolve the current conflict.

In step 512, the calculated queue time may be compared with maximum queue time constraints. In one embodiment, the maximum queue time constraint of a resource may be defined by a minimal value of a user defined constraint and a difference between the busy duration of the bottle-neck resource and the busy duration of the resource.

If the calculated queue time is within the maximum queue time constraint, the current individual schedule may be updated by adding the calculated queue time to delay the step with higher start time of the current conflict as shown in step 514.

In step 516, conflicts may be checked for the updated individual schedule and the current fundamental period. If no conflict exists, the method 500 found a solution. The current individual schedule and the current fundamental period may be output as a solution at step 520. However, if conflicts are detected in step 516, the method goes to step 518, wherein the current conflict is set to the first conflict in the updated schedule. The method then jumps back to step 506.

Referring back to step 512, if the calculated queue time does not satisfy requirement of the maximum queue time constraint, the algorithm jumps to step 522.

In step 522, the current conflict is reversed, in which a queue time required to delay the step with lower start time and remove the current conflict is calculated. In one embodiment, a counter relates to the current conflict is set to 2 to mark the times of attempts made to resolve the current conflict.

In step 524, the calculated queue time from step 522 is compared with the maximum queue time constraint. If the calculated queue time satisfies the maximum queue time constraint, the method jumps to step 514 to update the current individual schedule. However, if the calculated queue time does not satisfy the maximum queue time constraint, the current conflict is removed from the conflict history in step 526.

In step 528, the conflict history is checked. If the conflict history is empty, the method jumps to step 532. In step 532, the current fundamental period is rejected and the method returns no solution to remove the resource conflicts.

If the conflict history is not empty, the method goes on to step 530, where the current conflict is rolled back and set to the last removed conflict stored in the conflict history. The method jumps to step 521.

In step 521, a counter associated with the current conflict is checked. The counter equals two indicates that the current conflict has been solved twice, i.e. forward solution (higher step delayed) and reverse solution (lower step delayed). The counter is one indicating that only a forward solution has been attempted. In step 521, if the counter equals two, the method jumps to step 526 to remove the current conflict from the conflict history and roll back one more step. If the counter equals one, the method goes to step 522 to try to reverse the current conflict.

Referring back to step 506, if the current conflict is in the conflict history, the method jumps to step 521 to decide if both forward and reverse solutions have been attempted.

Periodic clean

Periodic cleans are recipes that are run every W substrates in a step of a process sequence. Since periodic cleans are not executed every substrate, they cannot be included in the normal schedule process.

In one embodiment of the present invention, periodic cleans are treated as special case of scheduling. Periodic cleans are only used in the calculation of the fundamental period. Busy duration of the bottle neck resource or fundamental period can be viewed as the time elapsed between start times of two subsequent substrates. Since the calculated fundamental period is used to feed substrates into the cluster tool, each chamber (assigned for a single step and being the only chamber for the single step) receives a substrate every calculated fundamental period. If the chamber is able to complete the substrate processing within the calculated fundamental period, the chamber will be conflict free. Substrate processing in the chamber generally includes the recipe time, substrate transfer time and any post processing needed by the chamber. In one embodiment, the scheduler includes the periodic clean recipe time to calculate the fundamental period so that the periodic clean may also be completed in the chamber before the next substrate arrives.

In one embodiment of the present invention, the periodic cleans are not considered when calculating the fundamental period. Then the scheduler iterates through all the chambers in the system which have periodic cleans requirements and tests if the periodic clean can be completed within the calculated fundamental period in addition to substrate process time, substrate transfer time and any added queue time. If the periodic clean can be completed before the next substrate arrives, the calculated fundamental period may be used for scheduling.

If the periodic clean cannot be completed before the next substrate arrives, the fundamental period is increased such that the periodic cleans can be completed within the increased fundamental period.

In case there are more than one chamber used in the step, the scheduler considers staggering the usage of the chambers in the step. At any given time only one chamber is used for all the substrates, until the periodic clean is triggered. Once the periodic clean condition is reached, the sequencer starts sending substrates to the next chamber in the group while the first chamber runs the periodic clean recipe. Thus in a step where N chambers are used, at any given moment of time, (N-1) chamber could be executing periodic cleans while one of the chambers is processing the substrates. This ensures a stall free execution. If, however, the periodic clean recipe is so long that it cannot be completed within N times of the fundamental period, the periodic clean will cause the system to stall. The stall time is equal to:

$$\text{Stall Time} = (\text{Periodic clean recipe time}) - N * \text{Fundamental period};$$

The scheduler stalls for duration of calculated stall time every N+1 substrates.

Figure 8 illustrates a flow chart of a method 600 for determining a periodic cleaning schedule in accordance with one embodiment of the present invention.

In step 602, for every step that requires periodic chamber cleaning, the method 600 check if there are more than one chamber are used.

If there is only one chamber for a step that requires periodic clean, the method tests if the periodic clean can be completed within the fundamental period in addition to substrate process time, substrate transfer time and any added queue time, in step 604.

If the periodic clean can be completed within in the fundamental period in addition to the process time, transfer time and added queue time, the scheduler sets a periodic clean to be performed within in the fundamental period, as shown in step 606.

However, If the periodic clean cannot be completed within in the fundamental period in addition to the process time, transfer time and added queue time, the scheduler extends the fundamental period such that a periodic clean may be performed within in the fundamental period, as shown in step 608.

Referring back to step 602, if there are more than one chambers for a step that requires periodic cleaning, the scheduler jumps to step 612 to determine if cleaning time is longer than N times of the fundamental period, wherein N is the number of chambers to available to perform the step.

If the cleaning time is shorter than N times of the fundamental period, periodic cleaning may be arranged using current fundamental period.

If the cleaning time is longer than N time of the fundamental period, the scheduler jumps to step 614 to calculate a stall time every N substrates to perform periodic cleaning.

**Runtime variation and dynamic schedule adjustment**

In one embodiment of the present invention, a static schedule is created before a sequencer (which controls a process sequence in a cluster tool) starts and is used as an input to decide movements in a cluster tool. Before starting any substrate transfer jobs, the sequencer queries the scheduler to see if any additional delays are required to avoid conflicts. However since the actual time taken to execute the recipe may vary, especially in end point based recipes, the scheduler also monitors the system while the process sequence is being executed. The scheduler then adjusts the delays calculated in the static schedule based on the actual times. For example, the start time of step k was at time=100 seconds and the delay after the step was 30 seconds in the static schedule. If a substrate arrives at the chamber at time=102 seconds because of substrate transfer time variations, the scheduler will adjust the sequencer to wait only 28 seconds after the substrate has complete the recipes.

**Example**

A simple example using methods of the present invention to schedule a process sequence is provided. A single cluster tool having three chambers CH1, CH2, CH3 with a single blade robot R1 to perform all substrate transferring among chambers CH1, CH2, CH3. Two load locks LLA, LLB are used to move substrates into and out of the single cluster tool. A single blade factory interface robot FI is used for transfers between cassettes and the load locks LLA, LLB.

An input sequence and recipe times are shown in Table 7. Table 8 shows the calculations and relative start and end time and the conflicts of moves at robot R1.

Table 7: Input Sequence

| Step Number | Chamber | Recipe Time |
|---|---|---|
| 1 | LLA | 20 |
| 2 | CH1 | 30 |
| 3 | CH2 | 30 |
| 4 | CH3 | 30 |
| 5 | LLB | 20 |

Table 8: Scheduler table (The Relative start and end are calculated from the Fundamental period in Table 9.)

| Step No | Chamber/ Robot | Recipe Times | Xfer Times | Step Start | Step End | Move Start | Move End | Relative Start | Relative End | Remarks |
|---|---|---|---|---|---|---|---|---|---|---|
| 1 | CASS | 0 | | 0 | 0 | | | 0 | 0 | |
| | FI robot | | 10 | | | 0 | 10 | 0 | 10 | |
| 2 | LLA | 20 | | 10 | 30 | | | 10 | 30 | |
| | R1 | | 22 | | | 30 | 52 | 30 | 52 | Conflict with move 5 |
| 4 | CH1 | 30 | | 52 | 82 | | | 52 | 82 | |
| | R1 | | 30 | | | 82 | 112 | 82 | 8 | Conflict with move 6 |
| 5 | CH2 | 30 | | 112 | 142 | | | 8 | 38 | |
| | R1 | | 30 | | | 142 | 172 | 38 | 68 | |
| 6 | CH3 | 30 | | 172 | 202 | | | 68 | 98 | |
| | R1 | | 22 | | | 202 | 224 | 98 | 16 | |
| 7 | LLB | 20 | | 224 | 244 | | | 16 | 36 | |
| | FI robot | | 10 | | | 244 | 254 | 36 | 46 | |
| 8 | CASS | 0 | | | | | | | | |

Table 9: Fundamental period calculations

| No | Resource | Busy Duration | Remarks |
|---|---|---|---|
| 1 | CASS | 20 | Move 1 time + Move 7 time |
| 2 | FI robot | 20 | Same as above |
| 3 | LLA | 52 | Step 2 recipe time + move 1 time + move 2 time |
| 4 | CH1 | 82 | |
| 5 | CH2 | 90 | |
| 6 | CH3 | 82 | |
| 7 | LLB | 52 | |
| 8 | R1 | 104 | Sum of move times for Move 2 to Move 6 |
| Bottle neck Resource | R1 | 104 | Maximum busy duration |

The Relative Times in table 8 are calculated based on the fundamental period calculated in Table 9. As depicted in the 'Remarks' column there are two conflicts that should be resolved to complete the schedule. A solution is found and shown in Table 10.

Table 10 Solution Fundamental period = 104 seconds, Throughput = 34.6 substrates / hour

| Step No | Chamber/ Robot | Recipe Times | Xfer Times | Step Start | Step End | Queue Time | Move Start | Move End | Relatve Start | Relative End |
|---|---|---|---|---|---|---|---|---|---|---|
| 1 | CASS | 0 | | 0 | 0 | 0 | | | 0 | 0 |
| | FI robot | | 10 | | | | 0 | 10 | 0 | 10 |
| 2 | LLA | 20 | | 10 | 30 | 0 | | | 10 | 30 |
| | R1 | | 22 | | | | 30 | 52 | 30 | 52 |
| 4 | CH1 | 30 | | 52 | 82 | 0 | | | 52 | 82 |
| | R1 | | 30 | | | | 82 | 112 | 82 | 8 |
| 5 | CH2 | 30 | | 112 | 142 | 14 | | | 8 | 38 |
| | R1 | | 30 | | | | 156 | 186 | 52 | 82 |
| 6 | CH3 | 30 | | 172 | 202 | 0 | | | 82 | 8 |
| | R1 | | 22 | | | | 216 | 238 | 8 | 30 |
| 7 | LLB | 20 | | 224 | 244 | 0 | | | 30 | 50 |
| | FI robot | | 10 | | | | 258 | 270 | 50 | 60 |
| 8 | CASS | 0 | | | | | | | | |

Embodiments of the present invention can be implemented as a program product for use with a computer system to control a cluster tool configured to perform a process sequence. The program(s) of the program product defines functions of the embodiments of the present invention and can be contained on a variety of signal-bearing media. Illustrative signal-bearing media include, but are not limited to: (i) information permanently stored on non-writable storage media (e.g., read-only memory devices within a computer such as CD-ROM disks readable by a CD-ROM drive); (ii) alterable information stored on writable storage media (e.g., floppy disks within a diskette drive or hard-disk drive); or (iii) information conveyed to a computer by a communications medium, such as through a computer or telephone network, including wireless communications. The latter embodiment specifically includes information downloaded from the Internet and other networks. Such signal-bearing media, when carrying computer-readable instructions that direct the functions of the present invention, represent embodiments of the present invention.

In general, the routines executed to implement the embodiments of the invention, may be part of an operating system or a specific application, component, program, module, object, or sequence of instructions. More specifically, the routines executed to implement the embodiments of the present invention may by part of automated scripts that are triggered at initial program load (IPL) time, for instance. The computer program of the present invention is typically comprised of a multitude of instructions that will be translated by the native computer into a machine-readable format and hence executable instructions. Also, programs are comprised of variables and data structures that either reside locally to the program or are found in memory or on storage devices. In addition, various programs described hereinafter may be identified based upon the application for which they are implemented in a specific embodiment of the invention. However, it should be appreciated that any particular program nomenclature that follows is used merely for convenience, and thus the invention should not be limited to use solely in any specific application identified and/or implied by such nomenclature.

Even though only cluster tools for generating gate poly silicon are described in this application, the present invention may be adapted to other processing tool where a sequence of processing steps may be performed. A person skilled in the art may adapt the present invention in applicable circumstances.

While the foregoing is directed to embodiments of the present invention, other and further embodiments of the invention may be devised without departing from the basic scope thereof, and the scope thereof is determined by the claims that follow.

**Claims**

1. A method for scheduling a process sequence, comprising:

    determining (410) an individual schedule by assigning resources to perform the process sequence (200), wherein the individual schedule comprises start times indicating when an individual substrate starts a plurality of process steps in the process sequence;
    calculating (420) a fundamental period, wherein the fundamental period is defined as time duration between start times of two sequential substrates;
    detecting (440) resource conflicts in a schedule generated from the individual schedule and the fundamental period; and
    adjusting (450) the individual schedule to remove a detected resource conflict.

2. The method of claim 1, wherein the detecting resource conflicts and adjusting the individual schedule are reiterated until no resource conflict is detected.

3. The method of claim 1 or 2, wherein adjusting the individual schedule comprises adding a queue time to delay a process step associated with the detected resource conflict to be removed.

4. The method of any of claims 1 to 3, wherein the process step being delayed has a higher starting time compared to another process step associated with the resource conflict to be removed.

5. The method of any of claims 1 to 4, wherein adjusting individual schedule further comprises restricting the queue time to within a queue time constraint.

6. The method of any of claims 1 to 5, wherein determining (420) the fundamental period comprises:

    calculating busy durations for all the resources assigned to perform the process sequence; and
    setting the fundamental period according to the longest busy duration of all the resources assigned to perform the process sequence.

7. The method of any of claims 1 to 6, further comprising:

    extending (480) the fundamental period when resource conflicts cannot be removed by adjusting the individual schedule;
    detecting (440) resource conflicts in an updated schedule generated from the individual schedule and the extended fundamental period; and
    adjusting (450) the individual schedule to remove the resource conflicts in the updated schedule.

8. A computer readable medium containing a computer program for scheduling a process sequence, which, when executed by a process, performs operations comprising:

determining (410) an individual schedule by assigning resources to perform the process sequence, wherein the individual schedule comprises start times indicating when an individual substrate starts a plurality of process steps in the process sequence;

calculating (420) a fundamental period, wherein the fundamental period is defined as time duration between start times of two sequential substrates;

detecting (440) resource conflicts in a schedule generated from the individual schedule and the fundamental period; and

adjusting (450) the individual schedule to remove a detected resource conflict.

9. The computer readable medium of claim 8, wherein the detecting resource conflicts and adjusting the individual schedule are reiterated until no resource conflict is detected, and adjusting the individual schedule comprises adding a queue time to delay a process step associated with the detected resource conflict to be removed.

10. The computer readable medium of claim 8 or 9, wherein determining (420) the fundamental period comprises:

calculating busy durations for all the resources assigned to perform the process sequence; and
setting the fundamental period according to the longest busy duration of all the resources assigned to perform the process sequence.

11. The computer readable medium of any of claims 8 to 10, further comprising:

extending (480) the fundamental period when resource conflicts cannot be removed by adjusting the individual schedule;

detecting (440) resource conflicts in an updated schedule generated from the individual schedule and the extended fundamental period; and

adjusting (450) the individual schedule to remove the resource conflicts in the updated schedule.

12. A method for scheduling a processing sequence, comprising:

generating a processing schedule wherein there is no waiting period for each of a plurality of processing steps in the processing sequence;

determining a fundamental period according to a busy duration of a bottle neck resource;

detecting (440) resource conflicts in the processing schedule based on the fundamental period; and

adjusting (450) at least one of the processing schedule and the fundamental period to remove the detected resource conflicts.

13. The method of claim 12, wherein detecting resource conflicts comprising detecting conflicts of any resource that is occupied by two or more steps in the processing sequence.

14. The method of claim 12 or 13, wherein adjusting comprises inserting a queue time to delay a step associated with a resource conflict to be removed.

15. The method of any of claims 12 to 14, wherein adjusting comprises
inserting queue time to one or more processing steps to remove the detected conflicts of resources;
detecting (440) resource conflicts in the adjusted processing schedule based on the fundamental period; and
extending (480) the fundamental period if the detected conflicts recur.

FIG. 1

200

| PLACING A SUBSTRATE IN A CLUSTER TOOL | 202 |

| DEPOSITING A DIELECTRIC LAYER ON THE SUBSTRATE | 204 |

| EXPOSING THE DIELECTRIC LAYER TO A POST DEPOSITION ANNEAL PROCESS | 205 |

| EXPOSING THE DIELECTRIC LAYER TO AN INERT PLASMA PROCESS | 206 |

| EXPOSING THE DIELECTRIC LAYER TO A THERMAL ANNEALLING PROCESS | 208 |

| DEPOSITING A GATE ELECTRODE LAYER ON THE SUBSTRATE | 210 |

FIG. 2

EP 1 965 282 A2

```
        ┌─S1              ┌─S2              ┌─S3              ┌─S4              ┌─S5
   ┌──────────┐      ┌──────────┐      ┌──────────┐     ┌──────────┐      ┌──────────┐
   │   FOUP   │ ───▶ │  ALIGNER │ ───▶ │   LOAD   │ ──▶ │ TRANSFER │ ───▶ │ DPN + (A)│
   │          │      │          │      │ LOCK(A)  │     │ PLATFORM │      │          │
   └──────────┘      └──────────┘      └──────────┘     └──────────┘      └──────────┘
        M1               M2                 M3                M4                M5
```

FIG. 3A

FIG. 3B

EP 1 965 282 A2

0   100   200   300   400   500   600   700   800   900   1000   1100   1200   1300

| M1 | M2 | S3 | M3 | M4 | S5 | M5 | S6 | M6 | S7 | M8 | S8 | M8 | S9 | M9 | M10 | S11 | M11 | S12 | M12 |

FP = 240

FP

2nd | M1 | M2 | S3 | M3 | M4 | S5 | M5 | S6 | M6 | S7 | M8 | S8 | M8 | S9 | M9 | M10 | S11 |

FP = 240

2*FP

3rd | M1 | M2 | S3 | M3 | M4 | S5 | M5 | S6 | M6 | S7 | M8 | S8 | M8 | S9 |

FP = 240

3*FP

4th | M1 | M2 | S3 | M3 | M4 | S5 | M5 | S6 | M6 | S7 |

FP = 240

4*FP

5th | M1 | M2 | S3 | M3 | M4 | S5 | M5 | S6 |

FP = 240

5*FP

6th | M1 | M2 | S3 | M3 | M4 |

CONFLICT 1: M9 & M6 OF
THE 3rd SUBSTRATE

CONFLICT 2: M9 & M5 OF
THE 4th SUBSTRATE

CONFLICT 3: M12 & M1 OF
THE 5th SUBSTRATE

CONFLICT 4: M12 & M2 OF
THE 5th SUBSTRATE

FIG. 4

CONFLICT 1: M10 & M3 OF THE 5th SUBSTRATE

CONFLICT 2: M12 & M2 OF THE 6th SUBSTRATE

FIG. 5

400

```
410 ──┐  ┌─────────────────────────────────┐
        │ DETERMINING AN INITIAL INDIVIDUAL │
        │ SCHEDULE (WITHOUT QUEUE TIME)     │
        │ FOR A PROCESSING SEQUENCE         │
        └─────────────────────────────────┘
```

420 — DETERMINING AN INITIAL INDIVIDUAL FUNDAMENTAL PERIOD

430 — GENERATING A SCHEDULE TABLE FROM THE INITIAL INDIVIDUAL SCHEDULE AND THE INITIAL FUNDAMENTAL PERIOD

GENERATING AN UPDATED SCHEDULE TABLE FROM THE INITIAL INDIVIDUAL SCHEDULE AND THE EXTENDED FUNDAMENTAL PERIOD — 490

440

ARE THERE CONFLICTS IN THE SCHEDULE TABLE? — NO

YES

450

ADJUSTING THE INDIVIDUAL SCHEDULE TO REMOVE CONFLICTS

EXTENDING THE FUNDAMENTAL PERIOD

480

460

NO — FOUND A SOLUTION?

YES

470 — OUTPUT CURRENT INDIVIDUAL SCHEDULE AND FUNDAMENTAL PERIOD

FIG. 6

FIG. 7

502 — GIVEN A CURRENT INDIVIDUAL SCHEDULE AND A CURRENT FUNDAMENTAL PERIOD (WITH CONFLICTS)

504 — SET CURRENT CONFLICT=FIRST CONFLICT

506 — IS THE CURRENT CONFLICT IN CONFLICT HISTORY ?

508 — ADD CURRENT CONFLICT TO CONFLICT HISTORY

510 — FORWARD CURRENT CONFLICT (CALCULATE QUEUE-TIME REQUIRED IN THE HIGHER STEP TO REMOVE CURRENT CONFLICT) COUNTER=1

521 — COUNTER ==2?

522 — REVERSE CURRENT CONFLICT (CALCULATE QUEUE-TIME REQUIRED IN THE LOWER STEP TO REMOVE CURRENT CONFLICT), COUNTER=2

512 — IS THE CALCULATED QUEUE TIME WITHIN THE CONSTRAINT ?

524 — IS CALCULATED QUEUE TIME WITHIN THE CONSTRAINT ?

514 — UPDATE CURRENT INDIVIDUAL SCHEDULE

526 — REMOVE CURRENT CONFLICT FROM CONFLICT HISTORY

516 — ARE THERE CONFLICTS IN THE UPDATED INDIVIDUAL SCHEDULE AND CURRENT FUNDAMENTAL PERIOD?

528 — IS CONFLICT HISTORY EMPTY ?

530 — CURRENT CONFLICT=LAST REMOVED CONFLICT

518 — SET CURRENT CONFLICT=FIRST CONFLICT FOR THE UPDATED INDIVIDUAL SCHEDULE

532 — REJECT CURRENT FUNDAMENTAL PERIOD, NO SOLUTION FOUND

520 — SOLUTION FOUND, FOR CURRENT FUNDAMENTAL PERIOD

500

600

BEGIN

602

MULTIPLE
CHAMBERS USED
IN A STEP?

YES

NO

612

CLEANING TIME
≤
N*FUNDAMENTAL PERIOD
(N.NUMBER OF
CHAMBERS)

NO

YES

604

FUNDAMENTAL
PERIOD
≥
CLEANING TIME +
PROCESS TIME?

YES

608

EXTEND
FUNDAMENTAL
PERIOD

614

SYSTEM STALL
STALL TIME
=CLEANING TIME
-N*FUNDAMENTAL
PERIOD

606

PERIODICAL CLEANING
CAN BE PERFORMED
IN CURRENT
FUNDAMENTAL PERIOD

FIG. 8